# EUROPÄISCHE PATENTANMELDUNG

(11) **EP 4 440 250 A1**
(43) Veröffentlichungstag der Anmeldung: **02.10.2024**
(21) Anmeldenummer: 23164646.4
(22) Anmeldetag: 28.03.2023
(51) Int. Cl.: H05K 1/02, H05K 3/30, H05K 3/32, H01R 4/30, H01R 12/52, H01R 12/70, F16B 5/02, F16B 37/04

(54) **TOLERANZAUSGLEICH BEI STROMKONTAKT ZU LEITERPLATTE**

(71) Anmelder: Siemens Aktiengesellschaft, 80333 München (DE)
(72) Erfinder: Nieberlein, Klaus, 90471 Nürnberg (DE); Roppelt, Alexander, 91330 Eggolsheim (DE)
(74) Vertreter: Siemens Patent Attorneys

(57) **Zusammenfassung**

Eine Leiterplatte (1) weist eine Durchtrittsöffnung (4) und auf ihrer Oberseite (2) in einem die Durchtrittsöffnung (4) umgebenden Bereich eine Kontaktfläche (5) auf. Eine Befestigungshülse (6) weist einen Hülsenkopf (7) und einen Hülsenhals (8) auf. Die Befestigungshülse (6) ist von unten durch die Durchtrittsöffnung (4) der Leiterplatte (1) geführt, so dass der Hülsenkopf (7) an der Unterseite (3) der Leiterplatte (1) angeordnet ist und der Hülsenhals (8) durch die Durchtrittsöffnung (4) hindurch tritt. Eine Haltestruktur (9) ist unterhalb der Leiterplatte (1) relativ zur Leiterplatte (1) verdrehsicher fixiert, der Hülsenkopf (7) in der Haltestruktur (9). Der Hülsenhals (8) weist ein Innengewinde (11) zum Aufnehmen des Schraubenhalses einer Befestigungsschraube (12) auf.

## Beschreibung

Die vorliegende Erfindung geht aus von einer Leiterplattenstruktur,
- wobei die Leiterplattenstruktur eine Leiterplatte aufweist,
- wobei die Leiterplatte eine Durchtrittsöffnung aufweist.

Derartige Leiterplattenstrukturen sind allgemein bekannt. Sie werden beispielsweise bei Stromversorgungseinrichtungen für elektrische Antriebe eingesetzt.

Bei einer Leiterplattenstruktur der eingangs genannten Art müssen oftmals hohe Ströme der Leiterplatte zugeführt bzw. von der Leiterplatte abgeführt werden. Hierfür müssen entsprechende Kontaktmöglichkeiten vorhanden sein.

Im Stand der Technik erfolgen das Zuführen bzw. Abführen derartiger Ströme oftmals über Zwischenelemente, die in geometrischer Hinsicht ähnlich zu einem Dual-in-Line-Chip ausgebildet sind. Derartige Zwischenelemente weisen einen rechteckigen Zentralbereich auf, der an zwei einander gegenüberliegenden Rändern jeweils eine Reihe von massiven Pins aufweist, die in die Leiterplatte eingelötet werden. In ihrem Zentralbereich weisen die Zwischenelemente Gewinde auf, in welche Befestigungsschrauben eingedreht werden können. Beim Einlöten derartiger Zwischenelemente muss sehr genau darauf geachtet werden, dass der Zentralbereich des jeweiligen Zwischenelements exakt parallel zur Leiterplatte orientiert ist und den "richtigen" Abstand zur Oberfläche der Leiterplatte aufweist. Anderenfalls kann es zu erheblichen Verspannungen der Leiterplatte, zu großen Übergangswiderständen vom jeweiligen Zwischenelement zu einer mit dem Zwischenelement verbundenen Leiterstruktur mit einer damit einhergehenden lokalen Überhitzung und eventuell sogar zu einer Verquetschung oder anderen Beschädigungen der Leiterplatte kommen.

Alternativ ist es bekannt, Befestigungshülsen mit einem Hülsenkopf und einem Hülsenhals - sogenannte Lötmuttern - zu verwenden, welche mit ihrem Hülsenkopf auf die Oberseite der Leiterplatte aufgelötet werden. Der Hülsenhals ragt hierbei von der Oberseite der Leiterplatte weg. Der Hülsenkopf ist also zwischen der Oberseite der Leiterplatte und dem Hülsenhals angeordnet. Auch bei dieser Vorgehensweise muss beim Auflöten sehr genau darauf geachtet werden, dass der Hülsenkopf exakt parallel zur Leiterplatte orientiert ist. Weiterhin muss darauf geachtet werden, dass die Lötstelle nicht auf Zug beansprucht wird. Dies ist umso kritischer, weil die Hülsenköpfe üblicherweise nur eine sehr kleine Auflagefläche haben und die Kraft der Schrauben daher auf eine entsprechend kleine Fläche der Leiterplatte eingeleitet wird. Bei der Verwendung größerer Befestigungshülsen sind die Befestigungshülsen entsprechend größer und schwerer, so dass auf der Unterseite der Leiterplatte Probleme entstehen können. Dies gilt insbesondere dann, wenn an der Unterseite im entsprechenden Bereich ein Einpressmodul oder eine andere mechanische Konstruktion angeordnet werden soll.

Aus dem Firmenprospekt "Z-Ray Press-Fit Alignment Hardware" der Firma Samtec, abgerufen aus dem Internet am 03.03.2023 unter https://docs.rs-online.com/7262/A700000007153398.pdf sind verschiedene Elemente bekannt, die unter Presssitz in eine Leiterplatte eingebracht werden können. Bei Verwendung dieser Elemente muss die Leiterplatte erhebliche mechanische Kräfte aufnehmen können, was nicht stets gewünscht und oftmals nicht möglich ist. Auch muss die Leiterplatte mit hoher geometrischer Genauigkeit gefertigt werden. Darüber hinaus sind die Elemente starr in der Leiterplatte fixiert, so dass kein Ausgleich von Toleranzen bezüglich der Oberseite der Leiterplatte möglich ist. Ähnliche Einpresselemente werden auch von der Firma Würth Elektronik ICS GmbH & Co. KG, Niedernhall, Deutschland, angeboten und vertrieben.

Die Aufgabe der vorliegenden Erfindung besteht darin, Möglichkeiten zu schaffen, mittels derer eine elektrische Kontaktierung einer Leiterplatte möglich ist, über die große Ströme übertragen werden können. Gleichzeitig soll relativ zur Leiterplattenebene ein Toleranzausgleich möglich sein, und zwar sowohl in Bezug auf den Abstand von der Oberseite der Leiterplatte als auch in Bezug auf die Orientierung relativ zur Oberseite der Leiterplatte.

Die Aufgabe wird durch eine Leiterplattenstruktur mit den Merkmalen des Anspruchs 1 gelöst. Vorteilhafte Ausgestaltungen der Leiterplattenstruktur sind Gegenstand der abhängigen Ansprüche 2 bis 8.

Erfindungsgemäß wird eine Leiterplattenstruktur der eingangs genannten Art dadurch ausgestaltet,
- dass die Leiterplatte auf ihrer Oberseite in einem die Durchtrittsöffnung umgebenden Bereich eine Kontaktfläche aufweist,
- dass die Leiterplattenstruktur eine Befestigungshülse mit einem Hülsenkopf und einem Hülsenhals aufweist,
- dass die Befestigungshülse von unten durch die Durchtrittsöffnung der Leiterplatte geführt ist, so dass der Hülsenkopf an der Unterseite der Leiterplatte angeordnet ist und der Hülsenhals durch die Durchtrittsöffnung hindurch tritt,
- dass die Leiterplattenstruktur eine Haltestruktur aufweist, die unterhalb der Leiterplatte relativ zur Leiterplatte verdrehsicher fixiert ist,
- dass der Hülsenkopf in der Haltestruktur verdrehsicher fixiert ist und
- dass der Hülsenhals ein Innengewinde zum Aufnehmen des Schraubenhalses einer Befestigungsschraube aufweist.

An der Kontaktfläche kann ein großflächiger Kontakt mit einem Anschlusselement erfolgen. Das Anschlusselement kann beispielsweise als Kontakthülse ausgebildet sein, die über den Hülsenhals gestülpt wird und an die Kontaktfläche angedrückt wird. Die Kontakthülse besteht in der Regel aus Kupfer oder Messing.

Aufgrund der Anordnung der Befestigungshülse derart, dass der Hülsenkopf an der Unterseite der Leiterplatte angeordnet ist, können Zugbelastungen ohne weiteres aufgenommen werden. Ferner verringert sich die resultierende Bauhöhe, um welche die Befestigungshülse über die Oberseite der Leiterplatte übersteht. Gleichzeitig kann auch das Ausmaß, um welches die Befestigungshülse über die Unterseite der Leiterplatte hinausragt, gering gehalten werden.

Aufgrund der Haltestruktur kann das Drehmoment, das beim Eindrehen der Befestigungsschraube in das Innengewinde auftritt, von der Haltestruktur aufgenommen und sodann in die Leiterplatte eingeleitet werden, so dass die Befestigungshülse sich beim Eindrehen der Befestigungsschraube nicht mitdreht.

Vorzugsweise ist der Hülsenkopf in der Haltestruktur formschlüssig gehalten. Diese Ausgestaltung ist besonders einfach und zuverlässig zu realisieren. Beispielsweise kann der Hülsenkopf eine Polygonform aufweisen, insbesondere viereckig oder sechseckig ausgebildet sein.

In einer besonders bevorzugten Ausgestaltung weist der Hülsenhals an seinem vom Hülsenkopf abgewandten Ende im Vergleich zu seinem dem Hülsenkopf zugewandten Bereich einen vergrößerten Durchmesser auf und weist weiterhin der Hülsenhals an seinem vom Hülsenkopf abgewandten Ende Schlitze auf, so dass die Bereiche des Hülsenhalses zwischen den Schlitzen einfedern können.

Durch diese Ausgestaltung ist es möglich, eine ringförmige Kontakthülse, die mittels der Befestigungsschraube an die Kontaktfläche der Leiterplatte angedrückt wird, zusätzlich auch an ihrer Innenseite an die Bereiche zwischen den Schlitzen anzudrücken, so dass die ringförmige Kontakthülse zum einen bereits vor dem Eindrehen der Befestigungsschraube in das Innengewinde des Hülsenhalses fixiert ist und zum anderen auch über die Kontaktbereiche, an denen das ringförmige Kontaktelement an die Bereiche zwischen den Schlitzen angedrückt wird, einen Teil des Stromes fließen zu lassen. Im Ergebnis wird dadurch die Stromtragfähigkeit der Kontakthülse vergrö-βert.

Vorzugsweise ist ein Durchmesser der Durchtrittsöffnung größer als ein Durchmesser des Hülsenhalses, so dass der Hülsenhals in der Durchtrittsöffnung mit einem seitlichen Spiel angeordnet ist. Diese Ausgestaltung ermöglicht auf einfache Weise einen seitlichen Toleranzausgleich. Weiterhin wird auch ein vertikaler Toleranzausgleich erleichtert, weil zwischen der Leiterplatte und dem Hülsenhals keine Klemmung existiert, welche einen derartigen vertikalen Toleranzausgleich behindern könnte.

Die Haltestruktur kann, je nach Lage des Einzelfalls, nach Bedarf aus einem elektrisch isolierenden Material oder aus einem elektrisch leitenden Material bestehen. Im Falle eines elektrisch isolierenden Materials kann die Haltestruktur insbesondere aus einem Kunststoff bestehen, im Falle eines elektrisch leitenden Materials insbesondere aus Stahl. Insbesondere auf Metallen und Metalllegierungen basierende Materialien weisen oftmals erheblich größere strukturelle Festigkeiten auf, als sie mit Kunststoffen erreichbar sind.

Vorzugsweise weist die Befestigungshülse in einem Übergangsbereich vom Hülsenkopf zum Hülsenhals einen grabenartigen Freistich auf. In diesem Fall kann gezielt eingestellt werden, in welchem Bereich der Hülsenkopf durch die Befestigungsschraube an die Unterseite der Leiterplatte angedrückt werden kann. Weiterhin ist es möglich, den Hülsenkopf an der Unterseite der Leiterplatte an die Leiterplatte anzulöten und dennoch zu gewährleisten, dass Lot nicht durch die Durchtrittsöffnung der Leiterplatte hindurch auf die Oberseite der Leiterplatte gelangt.

Üblicherweise weist die Leiterplattenstruktur ein Leistungsmodul auf, das unterhalb der Leiterplatte angeordnet ist. Ein derartiges Leitungsmodul ist in der Regel mit der Leiterplatte in Verbindungsbereichen verbunden. Die Verbindung kann eine Steckverbindung sein. In vielen Fällen ist das Leistungsmodul mit der Leiterplatte verpresst. Vorzugsweise sind der Hülsenkopf und die Haltestruktur innerhalb eines von der Leiterplatte, dem Leistungsmodul und den Verbindungsbereichen begrenzten Volumens angeordnet. Insbesondere bei dieser Ausgestaltung zeigt die vorliegende Erfindung ihre vollen Vorteile.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Schnitt durch eine Leiterplattenstruktur,
- FIG 2: eine Draufsicht auf eine Leiterplatte,
- FIG 3: eine perspektivische Ansicht einer Befestigungshülse,
- FIG 4: eine mögliche Kontur eines Hülsenkopfes,
- FIG 5: eine perspektivische Schnittdarstellung einer Leiterplattenstruktur,
- FIG 6: eine perspektivische Darstellung einer Haltestruktur mit mehreren Befestigungshülsen,
- FIG 7: eine Befestigungshülse im Längsschnitt,
- FIG 8: eine weitere Befestigungshülse im Längsschnitt,
- FIG 9: eine perspektivische Darstellung der Befestigungshülse von FIG 8 und
- FIG 10: eine perspektivische Darstellung einer Leiterplattenstruktur.

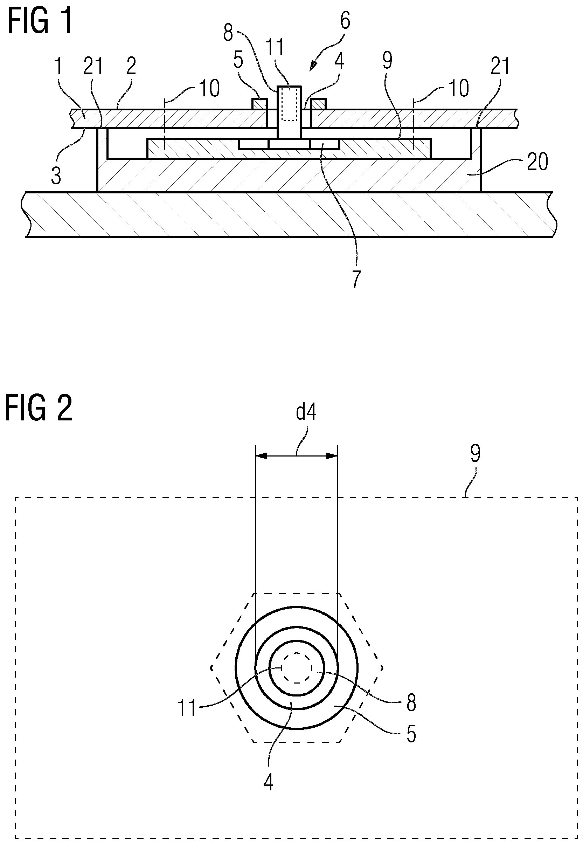

Gemäß FIG 1 weist eine Leiterplattenstruktur eine Leiterplatte 1 auf. Auf der Oberseite 2 und/oder der Unterseite 3 der Leiterplatte 1 - manchmal auch in Zwischenschichten zwischen der Oberseite 2 und der Unterseite 3 - sind Leiterbahnen angeordnet. Die Leiterbahnen sind nicht mit dargestellt, da sie im Rahmen der vorliegenden Erfindung von untergeordneter Bedeutung sind. Von Bedeutung ist hingegen, dass die Leiterplatte 1 eine Durchtrittsöffnung 4 aufweist. Die Durchtrittsöffnung 4 ist meist kreisrund und weist daher einen Durchmesser d4 auf (siehe auch FIG 2). Von Bedeutung ist weiterhin, dass die Leiterplatte 1 auf ihrer Oberseite 2 in einem die Durchtrittsöffnung 4 umgebenden Bereich eine Kontaktfläche 5 aufweist.

Die Leiterplattenstruktur weist weiterhin eine Befestigungshülse 6 mit einem Hülsenkopf 7 und einem Hülsenhals 8 auf. Die Befestigungshülse 6 ist von unten durch die Durchtrittsöffnung 4 geführt. Dadurch ist der Hülsenkopf 7 an der Unterseite 3 angeordnet und tritt weiterhin der Hülsenhals 8 durch die Durchtrittsöffnung 4 hindurch.

Die Leiterplattenstruktur weist weiterhin eine Haltestruktur 9 auf. Die Haltestruktur 9 besteht oftmals aus einem elektrisch isolierenden Material, insbesondere einem Kunststoff. In manchen Fällen kann sie aber auch aus einem elektrisch leitenden Material bestehen, insbesondere Stahl. Die Haltestruktur 9 ist unterhalb der Leiterplatte 1 angeordnet. Die Haltestruktur 9 ist relativ zur Leiterplatte 1 verdrehsicher fixiert. Beispielsweise kann die Haltestruktur 9, wie in FIG 1 durch gestrichelte Linien 10 angedeutet ist, mit der Leiterplatte 1 durch Schraubverbindungen verbunden sein. Die genaue Art und Weise der verdrehsicheren Fixierung der Haltestruktur 9 relativ zur Leiterplatte 1 ist jedoch von untergeordneter Bedeutung.

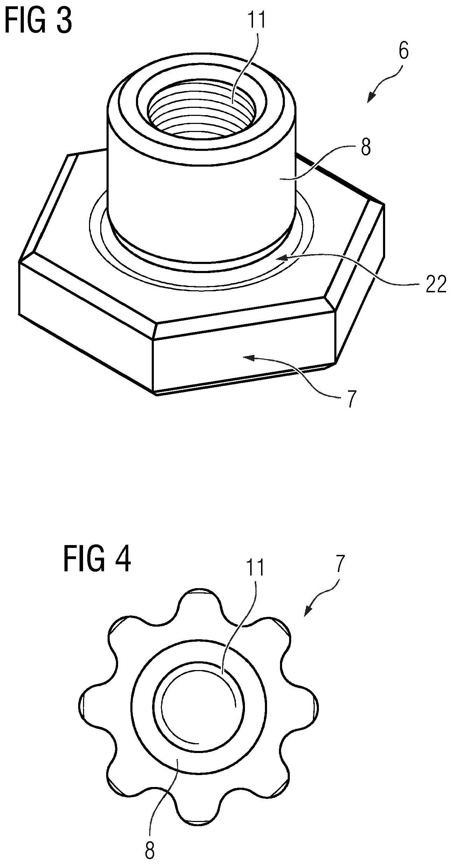

Der Hülsenkopf 7 ist in der Haltestruktur 9 verdrehsicher fixiert. Es ist möglich, dass diese verdrehsichere Fixierung durch einen Kraftschluss erreicht wird. Vorzugsweise ist der Hülsenkopf 7 jedoch in der Haltestruktur 9 formschlüssig gehalten. Beispielsweise kann der Hülsenkopf 7, wie in FIG 2 und auch in FIG 3 dargestellt ist, eine Polygonform aufweisen, insbesondere sechseckig ausgebildet sein. Es sind aber auch andere Polygonformen möglich, beispielsweise eine viereckige oder eine achteckige Ausbildung. Entscheidend für eine formschlüssige Fixierung ist, dass die Kontur des Hülsenkopfes 7 von der Kreisform verschieden ist. Beispielsweise kann der Hülsenkopf 7 sogar entsprechend der Darstellung in FIG 4 eine Kontur aufweisen, die wellenartig um eine zentrale Achse umläuft.

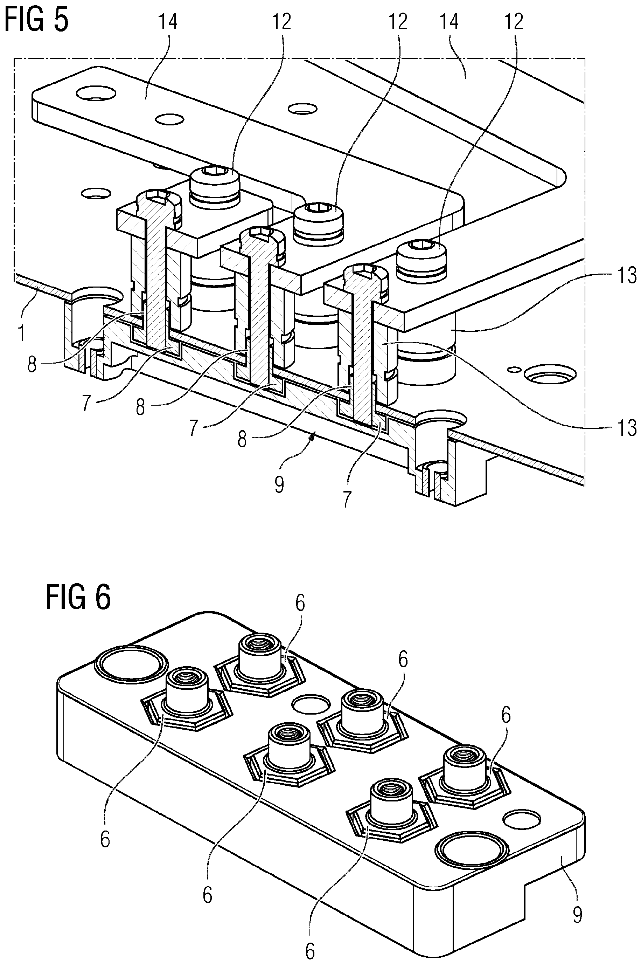

Der Hülsenhals 8 weist ein Innengewinde 11 auf. Von dem Innengewinde 11 kann eine Befestigungsschraube 12 (siehe rein beispielhaft FIG 5) aufgenommen werden, also im Ergebnis eingedreht werden.

FIG 5 zeigt weiterhin mehrere Sachverhalte, die zwar in der Regel realisiert sind und auch bei weiteren, nachstehend näher erläuterten Ausgestaltungen realisiert sein können, aber nicht zwingend erforderlich sind. So sind beispielsweise bei der Ausgestaltung von FIG 5 mehrere Befestigungshülsen 6 vorhanden. Weiterhin sind die Befestigungshülsen 6 in derselben Haltestruktur 9 verdrehsicher fixiert. Auch sind auf die Hülsenhälse 8 Kontakthülsen 13 aufgesetzt, wobei die Kontakthülsen 13 einerseits mit den zugehörigen Kontaktflächen 5 und andererseits mit Stromschienen 14 verbunden sind. Von den Kontakthülsen 13 und den Stromschienen 14 sind in FIG 5 nicht alle mit ihrem Bezugszeichen versehen.

FIG 6 zeigt isoliert die Haltestruktur 9, wie sie bei der Ausgestaltung gemäß FIG 5 verwendet wird. FIG 6 zeigt sehr deutlich die Polygonform der Hülsenköpfe 7 und auch die formschlüssige Fixierung der Befestigungshülsen 6 in der Haltestruktur 9.

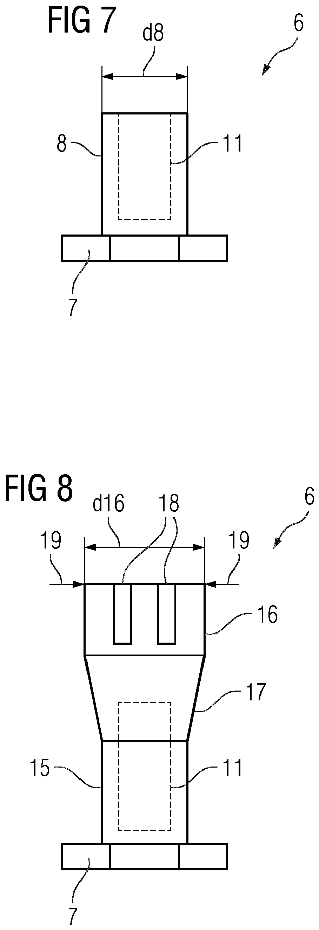

FIG 7 zeigt einen Schnitt durch eine typische Befestigungshülse 6. Gemäß FIG 7 (siehe ergänzend FIG 1) weist der Hülsenhals 8 einen Durchmesser d8 auf. Der Durchmesser d8 des Hülsenhalses 8 kann maximal so groß wie der Durchmesser d4 der Durchtrittsöffnung 4 sein. Vorzugsweise ist der Durchmesser d8 des Hülsenhalses 8 jedoch kleiner als der Durchmesser d4 der Durchtrittsöffnung 4. Dadurch wird erreicht, dass der Hülsenhals 8 in der Durchtrittsöffnung 4 mit einem seitlichen Spiel angeordnet ist. Das Spiel - im Ergebnis also die Differenz der Durchmesser d4 und d8 - liegt vorzugsweise im Bereich zwischen 1 mm und 3 mm.

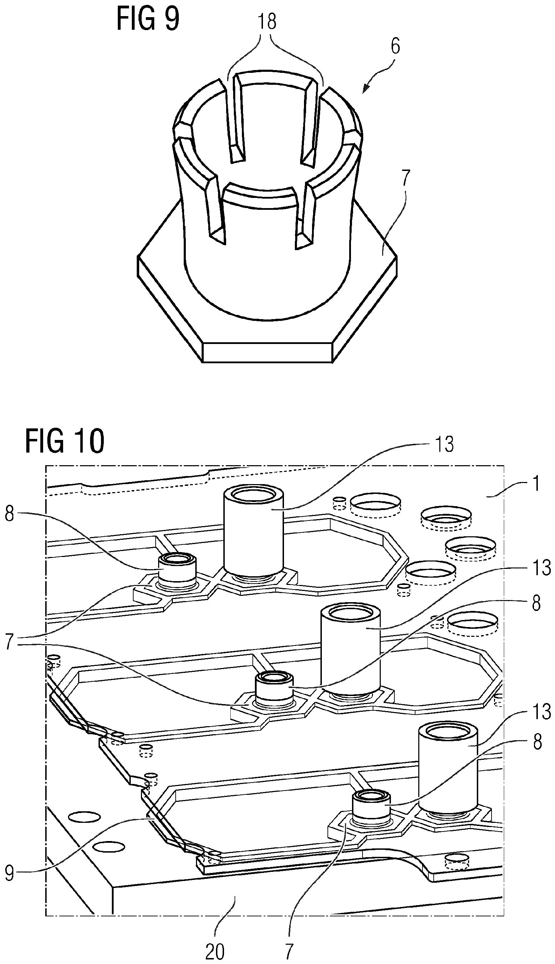

Die FIG 8 und 9 zeigen eine weitere, besonders bevorzugte Ausgestaltung der Befestigungshülse 6. Gemäß den FIG 8 und 9 weist der Hülsenhals 8 einen dem Hülsenkopf 7 zugewandten Bereich 15, ein vom Hülsenkopf 7 abgewandtes Ende 16 und dazwischen einen Übergangsbereich 17 auf. An seinem vom Hülsenkopf 7 abgewandten Ende 16 weist der Hülsenhals 8 im Vergleich zu seinem dem Hülsenkopf 7 zugewandten Bereich 15 einen vergrößerten Durchmesser d16 auf. Auch der Durchmesser d16 darf maximal so groß wie der Durchmesser d4 der Durchtrittsöffnung 4 sein. Weiterhin weist der Hülsenhals 8 an seinem vom Hülsenkopf 7 abgewandten Ende 16 Schlitze 18 auf. Die Schlitze 18 erstrecken sich zumindest im wesentlichen in der Längsrichtung des Hülsenhalses 8. Aufgrund dieser Ausgestaltung können die Bereiche des Hülsenhalses 8, die sich zwischen den Schlitzen 18 befinden, einfedern. Dies ist in FIG 8 durch entsprechende Pfeile 19 angedeutet.

In vielen Fällen weist die Leiterplattenstruktur entsprechend der Darstellung in FIG 1 (gestrichelt auch in FIG 2 angedeutet und auch in FIG 10 dargestellt) ein Leistungsmodul 20 auf. Das Leistungsmodul 20 trägt, sofern es vorhanden ist, Halbleiterschaltelemente. Beispielsweise kann es einen einzelnen Brückenzweig oder mehrere Brückenzweige einer Umrichterschaltung realisieren. Das Leistungsmodul 20 ist, sofern es vorhanden ist, in der Regel unterhalb der Leiterplatte 1 angeordnet. Unter dem Leistungsmodul 20 ist in der Regel ein Kühlkörper angeordnet (in FIG 1 angedeutet, aber nicht mit einem Bezugszeichen versehen).

Das Leistungsmodul 20 ist mit der Leiterplatte 1 in Verbindungsbereichen 21 verbunden. In FIG 10 sind die entsprechenden, vom Leistungsmodul 20 ausgehenden Pins erkennbar, die in die Leiterplatte 1 eingeführt sind. Die Verbindung des Leistungsmoduls 20 mit der Leiterplatte 1 kann insbesondere als Verpressung ausgebildet sein. Unabhängig von der konkreten Art der Verbindung begrenzen jedoch die Leiterplatte 1, das Leistungsmodul 20 und die Verbindungsbereiche 21 ein Volumen. Ersichtlich sind gemäß den Darstellungen in den FIG 1 und 10 der Hülsenkopf 7 und die Haltestruktur 9 innerhalb dieses Volumens angeordnet.

Insbesondere aus FIG 3 ist eine weitere bevorzugte Ausgestaltung der Befestigungshülse 6 erkennbar. Konkret weist die Befestigungshülse 6 gemäß FIG 3 in einem Übergangsbereich vom Hülsenkopf 7 zum Hülsenhals 8 einen grabenartigen Freistich 22 auf. Mittels des Freistichs 22 kann festgelegt werden, in welchen Bereichen der Hülsenkopf 7 gegebenenfalls an der Unterseite 3 der Leiterplatte 1 anliegen kann.

Zusammengefasst betrifft die vorliegende Erfindung somit folgenden Sachverhalt:
Eine Leiterplatte 1 weist eine Durchtrittsöffnung 4 und auf ihrer Oberseite 2 in einem die Durchtrittsöffnung 4 umgebenden Bereich eine Kontaktfläche 5 auf. Eine Befestigungshülse 6 weist einen Hülsenkopf 7 und einen Hülsenhals 8 auf. Die Befestigungshülse 6 ist von unten durch die Durchtrittsöffnung 4 der Leiterplatte 1 geführt, so dass der Hülsenkopf 7 an der Unterseite 3 der Leiterplatte 1 angeordnet ist und der Hülsenhals 8 durch die Durchtrittsöffnung 4 hindurch tritt. Eine Haltestruktur 9 ist unterhalb der Leiterplatte 1 relativ zur Leiterplatte 1 verdrehsicher fixiert, der Hülsenkopf 7 in der Haltestruktur 9. Der Hülsenhals 8 weist ein Innengewinde 11 zum Aufnehmen des Schraubenhalses einer Befestigungsschraube 12 auf.

Die vorliegende Erfindung weist viele Vorteile auf. Insbesondere ist auf einfache Art und Weise beim Verbinden einer Kontakthülse 13 (oder eines anderen Kontaktelements) sowohl ein lateraler als auch ein vertikaler Toleranzausgleich realisierbar, wobei dennoch auf ebenso einfache Art und Weise eine verdrehsichere Fixierung der Befestigungshülse 6 relativ zur Leiterplatte 1 erreicht werden kann. Dadurch können Verspannungen und andere Schäden an der Leiterplatte 1 vermieden werden. Weiterhin kann der elektrische Kontakt der Kontakthülse 13 (oder des anderen Kontaktelements) optimiert werden, so dass insbesondere lokale Überhitzungen zuverlässig vermieden werden können.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Leiterplattenstruktur,
- wobei die Leiterplattenstruktur eine Leiterplatte (1) aufweist,
- wobei die Leiterplatte (1) eine Durchtrittsöffnung (4) aufweist,
- wobei die Leiterplatte (1) auf ihrer Oberseite (2) in einem die Durchtrittsöffnung (4) umgebenden Bereich eine Kontaktfläche (5) aufweist,
- wobei die Leiterplattenstruktur eine Befestigungshülse (6) mit einem Hülsenkopf (7) und einem Hülsenhals (8) aufweist,
- wobei die Befestigungshülse (6) von unten durch die Durchtrittsöffnung (4) der Leiterplatte (1) geführt ist, so dass der Hülsenkopf (7) an der Unterseite (3) der Leiterplatte (1) angeordnet ist und der Hülsenhals (8) durch die Durchtrittsöffnung (4) hindurch tritt,
- wobei die Leiterplattenstruktur eine Haltestruktur (9) aufweist, die unterhalb der Leiterplatte (1) relativ zur Leiterplatte (1) verdrehsicher fixiert ist,
- wobei der Hülsenkopf (7) in der Haltestruktur (9) verdrehsicher fixiert ist und
- wobei der Hülsenhals (8) ein Innengewinde (11) zum Aufnehmen des Schraubenhalses einer Befestigungsschraube (12) aufweist.

2. Leiterplattenstruktur nach Anspruch 1,
**dadurch gekennzeichnet,**
**dass** der Hülsenkopf (7) in der Haltestruktur (9) formschlüssig gehalten ist.

3. Leiterplattenstruktur nach Anspruch 2,
**dadurch gekennzeichnet,**
**dass** der Hülsenkopf (7) eine Polygonform aufweist, insbesondere viereckig oder sechseckig ausgebildet ist.

4. Leiterplattenstruktur nach Anspruch 1, 2 oder 3,
**dadurch gekennzeichnet,**
**dass** der Hülsenhals (8) an seinem vom Hülsenkopf (7) abgewandten Ende (16) im Vergleich zu seinem dem Hülsenkopf (7) zugewandten Bereich (15) einen vergrößerten Durchmesser (d16) aufweist und dass der Hülsenhals (8) an seinem vom Hülsenkopf (7) abgewandten Ende (16) Schlitze (18) aufweist, so dass die Bereiche des Hülsenhalses (8) zwischen den Schlitzen (18) einfedern können.

5. Leiterplattenstruktur nach einem der obigen Ansprüche,
**dadurch gekennzeichnet,**
**dass** ein Durchmesser (d4) der Durchtrittsöffnung (4) größer als ein Durchmesser (d8) des Hülsenhalses (8) ist, so dass der Hülsenhals (8) in der Durchtrittsöffnung (4) mit einem seitlichen Spiel angeordnet ist.

6. Leiterplattenstruktur nach einem der obigen Ansprüche,
**dadurch gekennzeichnet,**
**dass** die Haltestruktur (9) aus einem elektrisch isolierenden Material, insbesondere einem Kunststoff, oder aus einem elektrisch leitenden Material, insbesondere Stahl, besteht.

7. Leiterplattenstruktur nach einem der obigen Ansprüche,
**dadurch gekennzeichnet,**
**dass** die Befestigungshülse (6) in einem Übergangsbereich vom Hülsenkopf (7) zum Hülsenhals (8) einen grabenartigen Freistich (22) aufweist.

8. Leiterplattenstruktur nach einem der obigen Ansprüche,
**dadurch gekennzeichnet,**
- **dass** die Leiterplattenstruktur ein Leistungsmodul (20) aufweist,
- **dass** das Leistungsmodul (20) unterhalb der Leiterplatte (1) angeordnet ist und mit der Leiterplatte (1) in Verbindungsbereichen (21) verbunden ist, insbesondere mit der Leiterplatte (1) verpresst ist, und
- **dass** der Hülsenkopf (7) und die Haltestruktur (9) innerhalb eines von der Leiterplatte (1), dem Leistungsmodul (20) und den Verbindungsbereichen (21) begrenzten Volumens angeordnet sind.
